# EUROPEAN PATENT APPLICATION

(11) **EP 2 051 190 A1**
(43) Date of publication of application: **22.04.2009**
(21) Application number: 07767181.6
(22) Date of filing: 19.06.2007
(51) Int. Cl.: G06K 19/077, G06K 19/07, B42D 15/10

(54) **METHOD FOR MANUFACTURING INLET FOR WIRELESS CARD, METHOD FOR MANUFACTURING WIRELESS CARD, INLET FOR WIRELESS CARD, AND WIRELESS CARD**

(30) Priority: 27.07.2006 JP 2006205130
(71) Applicant: Kabushiki Kaisha Toshiba, Minato-ku, Tokyo 105-8001 (JP)
(72) Inventor: IKEDA, Hidetaka, Tokyo 105-8001 (JP)
(74) Representative: Joly, Jean-Jacques
(86) International application number: PCT/JP2007/062323
(87) International publication number: WO 2008/013007

(57) **Abstract**

A method of manufacturing a transponder for a wireless card includes forming an antenna coil (3) on a film sheet (13), short-circuiting both end portions of the antenna coil (3) by a short-circuit portion (6), mounting an LSI (2) on the film sheet (13), electrically connecting a terminal of the LSI (2) to both ends of the antenna coil (3), and removing the short-circuit portion (6) after the LSI (2) is mounted.

## Description

### Technical Field

The present invention relates to a method of manufacturing a transponder for wireless cards used as commuter rail passes or the like, a method of manufacturing a wireless card, a wireless card transponder, and a wireless card.

### Background Art

As a representative method of manufacturing wireless cards used as commuter rail passes or the like, the following method is known.

First, an antenna is formed on a film sheet such as polyethylene terephthalate (PET), an LSI is mounted on the film sheet, a bump of the LSI is connected to the antenna, and thereby a transponder is manufactured. Then, a front sheet and a back sheet are superposed on the front and the back surfaces of the transponder, respectively, with an adhesive sheet interposed therebetween, and the sheets and the transponder are press-fitted and unified by applying heat and pressure on them. The united sheet is stamped into the card shape, and thereby a wireless card is manufactured (for example, refer to Jpn. Pat. Appln. KOKAI Pub. No. 11-59040).

### Disclosure of Invention

In the meantime, the above film sheet easily builds up static for the property of the material thereof. Therefore, in prior art, static electricity build up on the film sheet may flow into the LSI and break the LSI when the transponder is manufactured.

An aspect of the present invention has been made in view of the above circumstances. The object of the invention is to provide a method of manufacturing a transponder for wireless card, a method of manufacturing a wireless card, a wireless card transponder, and a wireless card, which prevent static electricity build up in manufacturing the transponder from flowing into the LSI.

According to an aspect of the invention, there is provided a method of manufacturing a transponder for a wireless card, comprising forming an antenna coil on a film sheet, and short-circuiting both end portions of the antenna coil by a short-circuit portion, mounting an LSI on the film sheet, and electrically connecting a terminal of the LSI to both ends of the antenna coil, and removing the short-circuit portion after the LSI is mounted.

According to an aspect of the invention, there is provided a method of manufacturing a wireless card, comprising forming an antenna coil on a film sheet, and short-circuiting both end portions of the antenna coil by a short-circuit portion, mounting an LSI on the film sheet, and electrically connecting a terminal of the LSI to both ends of the antenna coil, removing the short-circuit portion after the LSI is mounted,
superposing a front-surface sheet on a front surface of the film sheet, and superposing a back-surface sheet on a back surface of the film sheet,
press-fitting and uniting the superposed front-surface and the back-surface sheets and the film sheet, and stamping the united front-surface and back-surface sheets and the film sheet into a card shape along a peripheral portion of the antenna coil.

According to an aspect of the invention, there is provided a wireless card transponder comprising a film sheet, an antenna coil formed on the film sheet, a short-circuit portion which short-circuits both end portions of the antenna coil, and an LSI which is mounted on the film sheet and has a terminal electrically connected to both ends of the antenna coil, wherein the short-circuit portion is removed after the LSI is mounted.

According to an aspect of the invention, there is provided a wireless card comprising a film, an antenna coil formed on the film, a short-circuit portion which short-circuits both end portions of the antenna coil, an LSI which is mounted on the film and has a terminal electrically connected to both ends of the antenna coil, and a front-surface sheet and a back-surface sheet which are superposed on a front surface and a back surface of the film, respectively, and united with the film, wherein the short-circuit portion is removed after the LSI is mounted.

### Brief Description of Drawings

FIG. 1 is a diagram illustrating an equivalent circuit of a wireless card according to an embodiment of the present invention.
FIG. 2 is a side cross-sectional view of the wireless card of FIG. 1.
FIG. 3 is a diagram illustrating a film sheet which is a constituent member of the wireless card of FIG. 2.
FIG. 4 is a diagram illustrating antenna coils formed on the film sheet of FIG. 3.
FIG. 5A is a diagram illustrating a method of mounting an LSI on the film sheet of FIG. 3.
FIG. 5B is a diagram illustrating the method of manufacturing an LSI on the film sheet of FIG. 3.
FIG. 5C is a diagram illustrating the method of manufacturing an LSI on the film sheet of FIG. 3.
FIG. 5D is a diagram illustrating the method of manufacturing an LSI on the film sheet of FIG. 3.
FIG. 5E is a diagram illustrating the method of manufacturing an LSI on the film sheet of FIG. 3.
FIG. 5F is a diagram illustrating the method of manufacturing an LSI on the film sheet of FIG. 3.
FIG. 5G is a diagram illustrating the method of manufacturing an LSI on the film sheet of FIG. 3.
FIG. 6 is a diagram illustrating a transponder sheet obtained by mounting LSIs on the film sheet of FIG. 3.
FIG. 7 is an enlarged view of a short-circuit pattern which short-circuits both end portions of an antenna coil of FIG. 4.
FIG. 8 is a diagram illustrating a state where the short-circuit pattern of FIG. 7 is removed.
FIG. 9A is a diagram illustrating a method of manufacturing a wireless card.
FIG. 9B is a diagram illustrating the method of manufacturing a wireless card.
FIG. 9C is a diagram illustrating the method of manufacturing a wireless card.
FIG. 10 is a diagram illustrating a transponder sheet according to a second embodiment of the present invention.
FIG. 11 is an enlarged view of a short-circuit pattern which short-circuits both end portions of an antenna coil of the transponder sheet illustrated in FIG. 10.
FIG. 12A is a diagram illustrating a method of manufacturing a wireless card by using the transponder sheet of FIG. 10.
FIG. 12B is a diagram illustrating the method of manufacturing a wireless card by using the transponder sheet of FIG. 10.
FIG. 12C is diagram illustrating the method of manufacturing a wireless card by using the transponder sheet of FIG. 10.
FIG. 13 is a diagram illustrating a state where the short-circuit pattern of the antenna pattern is cut by stamping the laminated sheet when the wireless card of FIG. 12 is manufactured.

### Best Mode for Carrying Out the Invention

The present invention is described below with reference to embodiments illustrated in drawings.

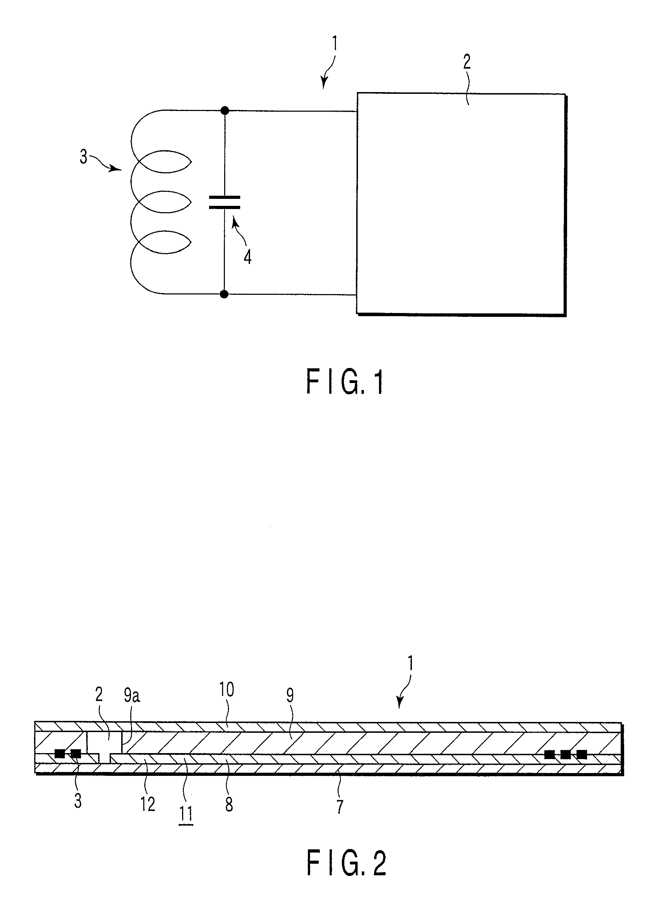

FIG. 1 illustrates an equivalent circuit of a wireless card 1 according to an embodiment of the present invention.

The wireless card 1 comprises an LSI 2, an antenna coil 3 which is electrically connected to the LSI 2, and a tuned capacitor 4 connected to the antenna coil 3.

The wireless card 1 operates the LSI 2 by converting electromagnetic waves supplied from the outside of the card into electric power, and performs data communication in a noncontact manner by sending back a response by the remaining electric power.

FIG. 2 is a side cross-sectional view of the wireless card 1.

In FIG. 2, reference number 7 denotes a back sheet. An antenna sheet 8 is superposed on the back sheet 7, and a front sheet 10 is superposed on the antenna sheet 8 with a spacer 9 interposed therebetween. The LSI 2 and the antenna coil 3 which is electrically connected to the LSI 2 are provided on the antenna sheet 8. The spacer 9 is provided with an opening portion 9a, and the LSI 2 is fitted into the opening portion 9a.

The antenna sheet 8 has a polyethylene terephthalate film (hereinafter referred to as "PET base material") 12 having a thickness of 38 µm. On one surface of the PET base material 12, the antenna coil 3 is formed by using an aluminum foil having a thickness of 30 µm. A transponder 11 is formed by mounting the LSI 2 on the antenna sheet 8. The LSI 2 is mounted by flip-chip packaging by using anisotropic conductive paste. The mounting method of the LSI 2 is not limited to flip-chip packaging, but may be other mounting methods.

Next, a method of manufacturing the above wireless card 1 is explained.

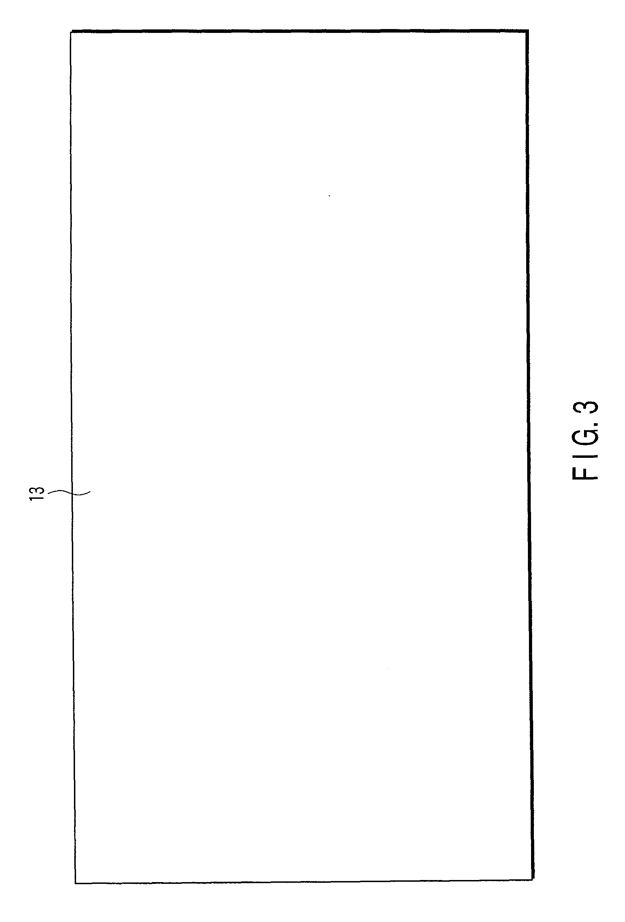

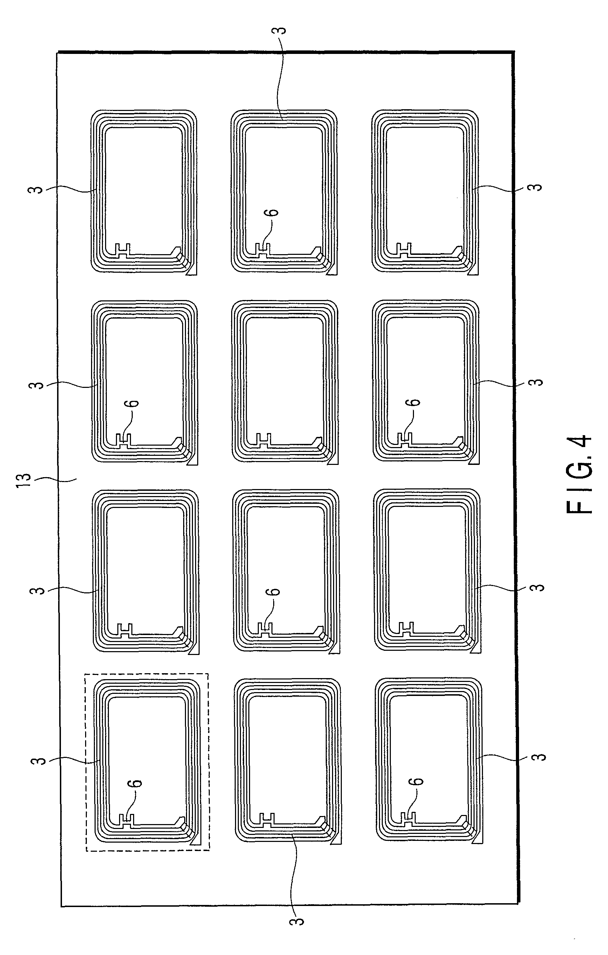

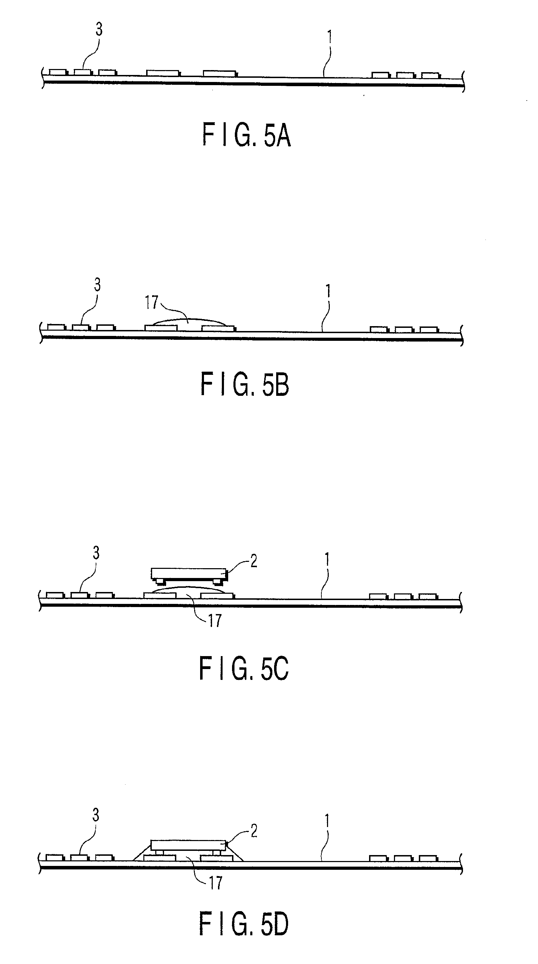

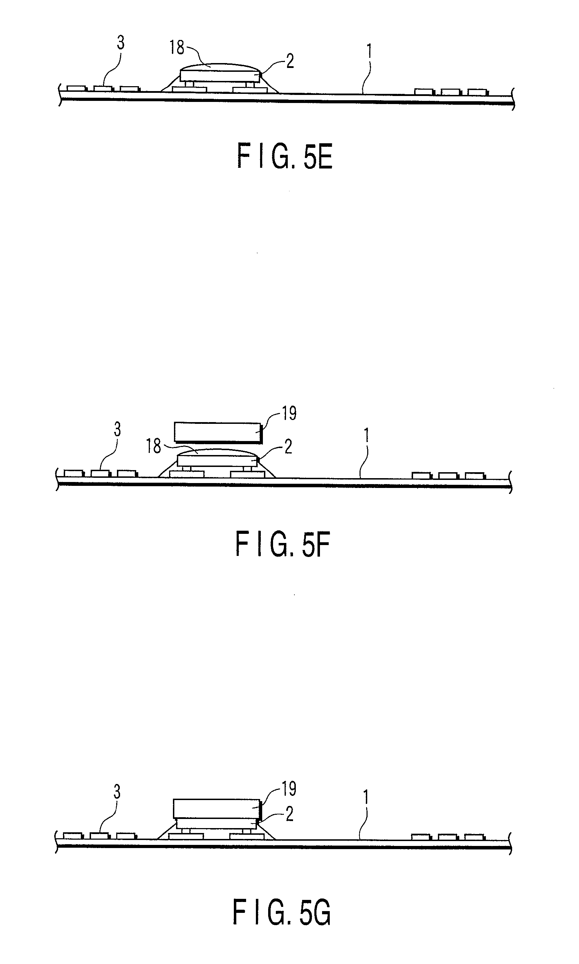

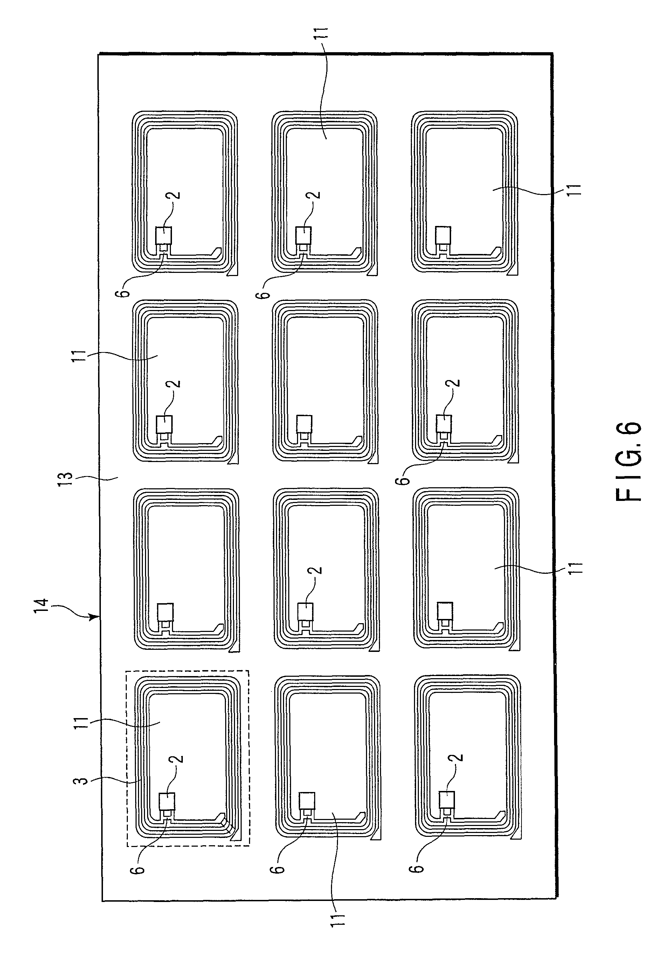

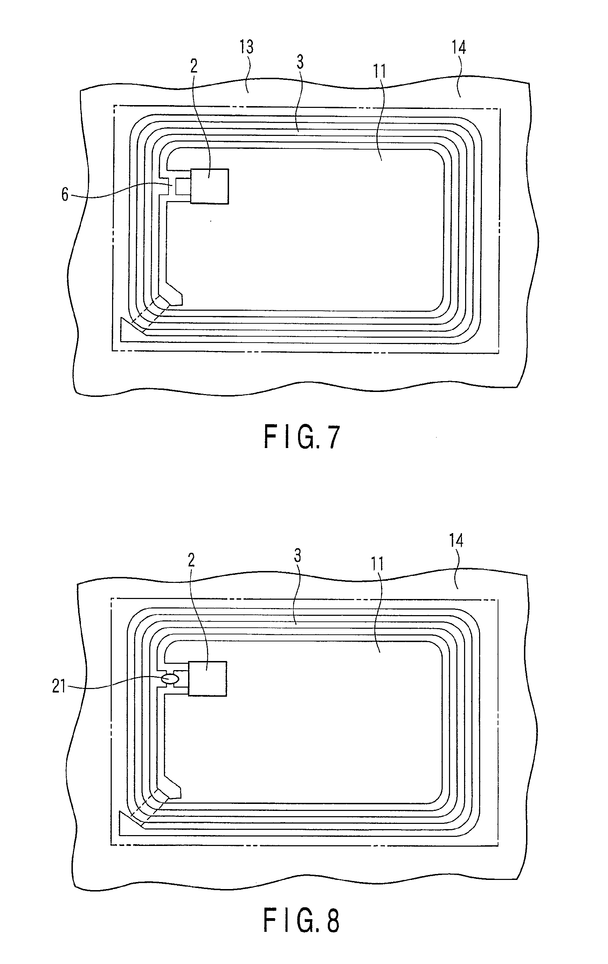

First, as illustrated in FIG. 3, a film sheet 13 is set. Then, as illustrated in FIGS. 4 and 5A, an antenna coil 3 is formed in each of areas on the film sheet 13, and both end portions of each antenna coil 3 are short-circuited by a short-circuit pattern 6 serving as a short-circuit portion, as illustrated in an enlarged view in FIG. 7. Thereafter, as illustrated in FIG. 5B, an anisotropic conductive adhesive (ACP) 17 is applied on the both ends of each antenna coil 3. After the application, as illustrated in FIG. 5C, an LSI 2 is mounted on the anisotropic conductive adhesive (ACP) 17, and the LSI 2 is subjected to thermocompression bonding and curing as illustrated in FIG. 5D. After the curing, an adhesive 18 is applied onto the LSI 2. Then, a reinforcing plate 19 is mounted on the adhesive 18 as illustrated in FIG. 5F, and subjected to thermocompression bonding and curing as illustrated in FIG. 5G. Thereby, a transponder sheet 14 having a plurality of transponders 11 as illustrated in FIG. 6 is manufactured.

After the transponder sheet 14 is formed as described above, a hole 21 is punched in the short-circuit pattern 6 on the end portions of the antenna coil 3 of each transponder 11 as illustrated in FIG. 8, and thereby the short-circuit pattern 6 is removed. After the removal, the transponders 11 are inspected, and then manufacturing of the transponders 11 is ended.

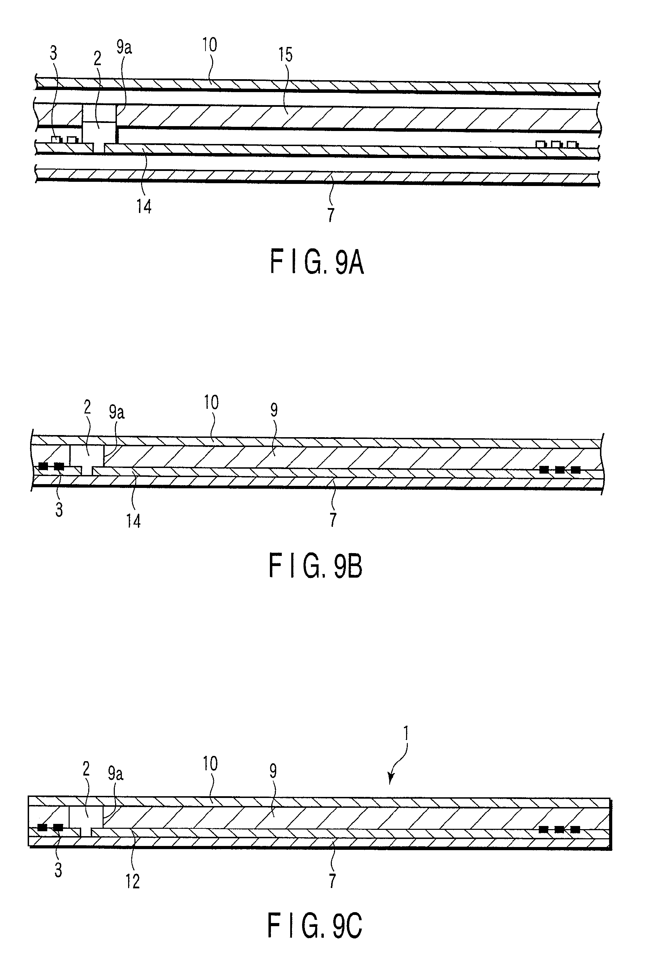

After the transponders 11 are manufactured as described above, the back sheet 7 is set as illustrated in FIG. 9A, and the transponder sheet 14 is superposed on the back sheet 7. Then, a spacer sheet 15 is superposed on the transponder sheet 14, and the front sheet 10 is superposed on the spacer sheet 15.

After the sheets are superposed as described above, the sheets are pressed and heated from above and below by a pressing and heating mechanism (not shown), and united as illustrated in FIG. 9B. Then, the united laminated sheet is cut into cards as illustrated in FIG. 9C along a peripheral portion (indicated by a broken line in FIG. 6) of each antenna coil 3, and manufacturing of the wireless card 1 is finished.

As described above, both end portions of each antenna coil 3 is short-circuited by the short-circuit pattern 6. Then, after the LSIs 2 are mounted and manufacturing of the transponders 11 is ended, each short-circuit pattern 6 is removed. Therefore, even when static electricity is build up during the manufacturing process of the transponders 11, the static electricity does not flow into the LSIs, and breakage of the LSIs 2 is prevented.

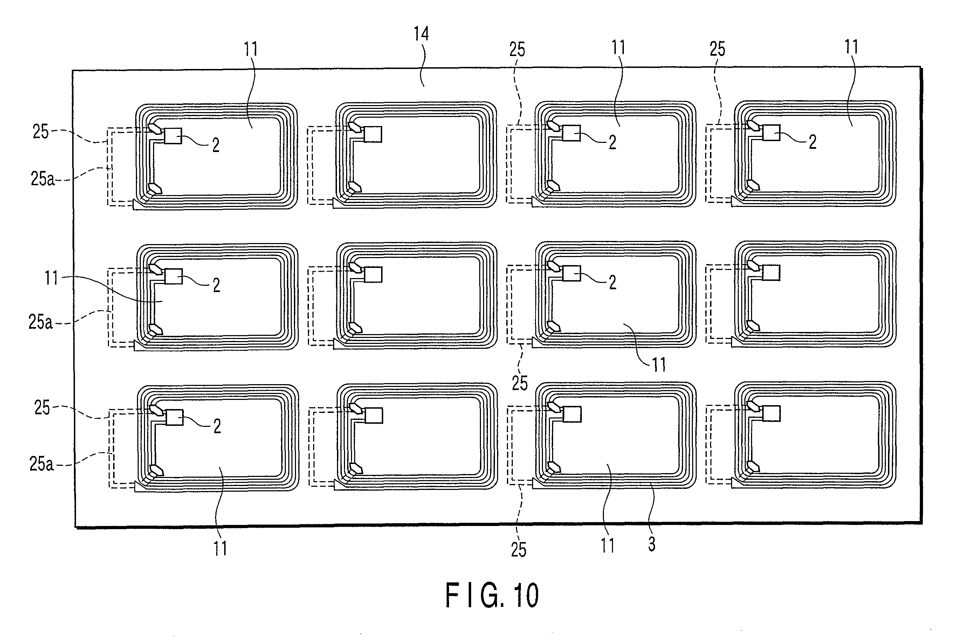

FIG. 10 is a plan view of a transponder sheet according to a second embodiment of the present invention.

The same constituent elements as those described in the above first embodiment are denoted by the same respective reference numbers, and detailed explanations thereof are omitted.

Although the transponder sheet 14 is manufactured by the same method as the method described in the above first embodiment, the structure of a short-circuit pattern 25 serving as a short-circuit pattern which short-circuits both end portions of each antenna coil 3 thereof is different from the first embodiment.

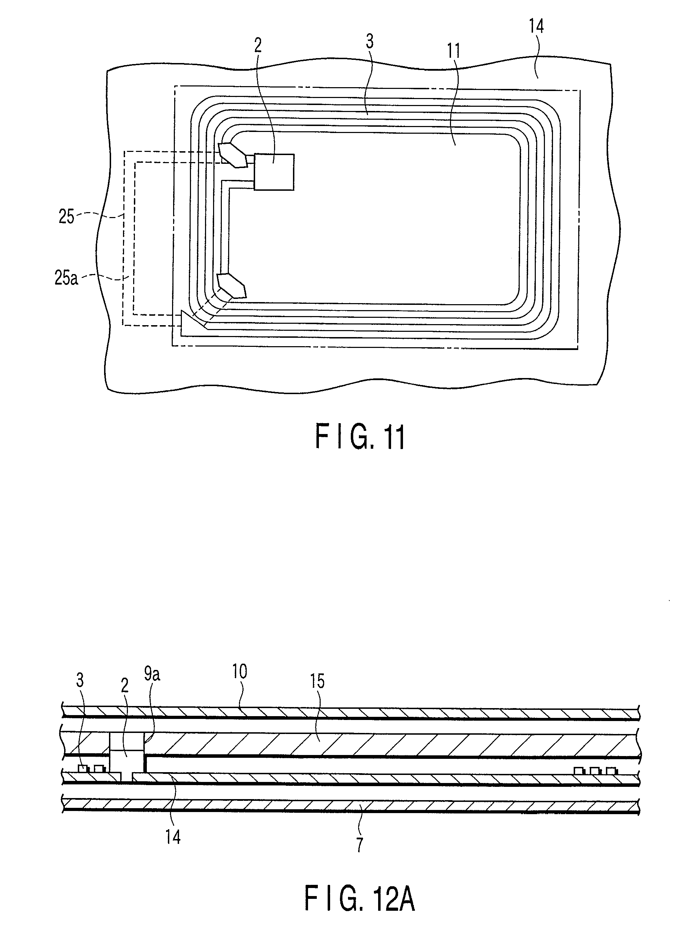

Specifically, in the above first embodiment, the short-circuit pattern 6 is located inside each antenna coil 3. In the second embodiment, a short-circuit pattern 25 which short-circuits both end portions of each antenna pattern 3 is provided in a state where an intermediate portion 25a thereof projects from a peripheral portion of the antenna coil 3 to the outside, as illustrated in an enlarged view in FIG. 11.

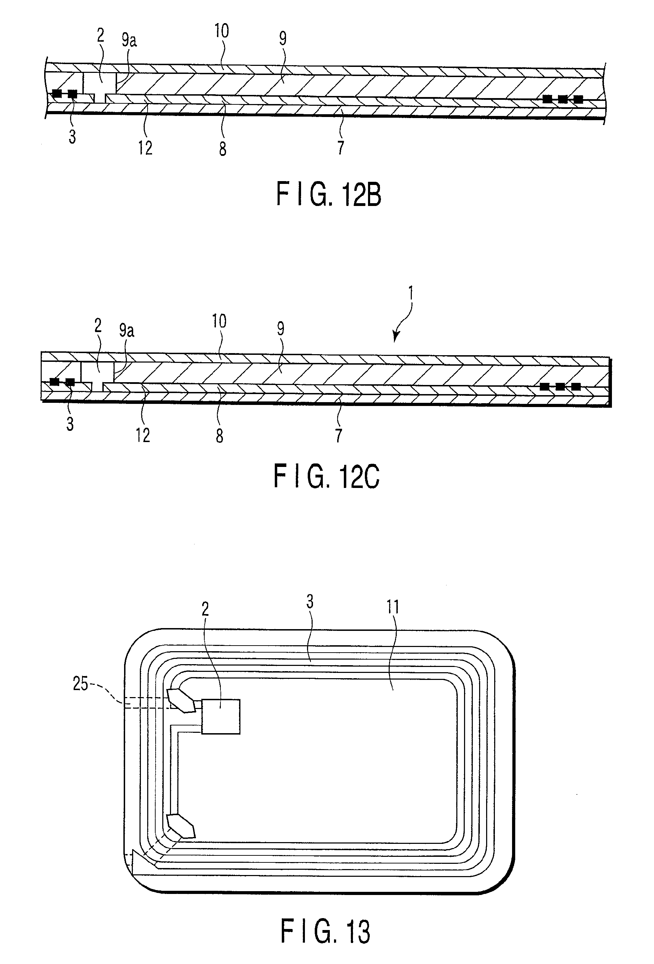

When wireless cards are manufactured by using the transponder sheet 14, a back sheet 7 is set and a transponder sheet 14 is superposed on the back sheet 7 as illustrated in FIG. 12A. Then, a spacer sheet 15 is superposed on the transponder sheet 14 with an adhesive sheet (not shown) interposed therebetween, and a front sheet 10 is superposed on the spacer sheet 15. Thereafter, the superposed sheets are pressed and heated from above and below by a pressing and heating mechanism (not shown), and united as illustrated in FIG. 12B.

Then, the united laminated sheet is cut along a peripheral portion (indicated by a broken line in FIG. 11) of each antenna coil 3. By the cutting, the laminated sheet is cut into cards as illustrated in FIG. 12C, and the intermediate portion 25a of the short-circuit pattern 25 which connects the both end portions of each antenna coil 3 is cut and removed as illustrated in FIG. 13. Thereby, each antenna coil 3 becomes operable, and manufacturing of the wireless cards is finished.

The second embodiment can also obtain the same advantageous effects as those of the above first embodiment.

In the above embodiments, a plurality of transponders 11 are formed on the transponder sheet 14, the front and the back sheets 10 and 7 are superposed on and united with the transponder sheet 14, and the laminated sheet is stamped into cards along the peripheral portion of the antenna coil 3 of each transponder 11. However, the present invention is not limited to this structure. For example, the transponders 11 formed one by one may be arranged on the back sheet 7, and the spacer sheet 15 and the front sheet 10 may be superposed on and united with the back sheet 7. Then, the laminated sheet may be stamped into cards along the peripheral portion of the antenna coil 3 of each transponder 11.

Further, the present invention is not limited to the above embodiments without any change, but may be realized when being carried out with various modifications of the constituent elements thereof, within a range not departing from the gist of the invention.

Further, various inventions may be formed by appropriate combinations of constituent elements disclosed in the above embodiments. For example, some constituent elements may be removed from the constituent elements disclosed in the above embodiments. Further, constituent elements of different embodiments may be used in combination.

### Industrial Applicability

According to an aspect of the present invention, both end portions of each antenna coil are short-circuited, and thereby the terminal of the LSI connected to the antenna coil can be set to the same potential. Thereby, it is possible to prevent static electricity from flowing into the LSIs in the manufacturing process, and prevent breakage of the LSIs.

## Claims

1. A method of manufacturing a transponder for a wireless card, comprising:
forming an antenna coil on a film sheet, and short-circuiting both end portions of the antenna coil by a short-circuit portion;
mounting an LSI on the film sheet, and electrically connecting a terminal of the LSI to both ends of the antenna coil; and
removing the short-circuit portion after the LSI is mounted.

2. A method according to claim 1, wherein
the short-circuit portion is removed by forming a punched hole.

3. A method according to claim 1, wherein
an intermediate portion of the short-circuit portion projects to outside of the antenna coil, and is removed by cutting the film sheet along a peripheral portion of the antenna coil.

4. A method according to claim 1, wherein
the antenna coil and the LSI are provided in each of areas on the film films.

5. A method of manufacturing a wireless card, comprising:
forming an antenna coil on a film sheet, and short-circuiting both end portions of the antenna coil by a short-circuit portion;
mounting an LSI on the film sheet, and electrically connecting a terminal of the LSI to both ends of the antenna coil;
removing the short-circuit portion after the LSI is mounted;
superposing a front-surface sheet on a front surface of the film sheet, and superposing a back-surface sheet on a back surface of the film sheet;
press-fitting and uniting the superposed front-surface and the back-surface sheets and the film sheet; and
stamping the united front-surface and back-surface sheets and the film sheet into a card shape along a peripheral portion of the antenna coil.

6. A method according to claim 5, wherein
the short-circuit portion is removed by forming a punched hole.

7. A method according to claim 5, wherein
an intermediate portion of the short-circuit portion projects to outside of the antenna coil, and is removed by cutting the film sheet along the peripheral portion of the antenna coil.

8. A method according to claim 5, wherein
the antenna coil and the LSI are provided in each of areas on the film films.

9. A wireless card transponder comprising:
a film sheet;
an antenna coil formed on the film sheet;
a short-circuit portion which short-circuits both end portions of the antenna coil; and
an LSI which is mounted on the film sheet and has a terminal electrically connected to both ends of the antenna coil,
wherein the short-circuit portion is removed after the LSI is mounted.

10. A wireless card comprising:
a film;
an antenna coil formed on the film;
a short-circuit portion which short-circuits both end portions of the antenna coil;
an LSI which is mounted on the film and has a terminal electrically connected to both ends of the antenna coil; and
a front-surface sheet and a back-surface sheet which are superposed on a front surface and a back surface of the film, respectively, and united with the film,
wherein the short-circuit portion is removed after the LSI is mounted.
